# EUROPEAN PATENT SPECIFICATION

(11) **EP 3 934 461 B1**
(45) Date of publication and mention of the grant of the patent: **12.02.2025**
(21) Application number: 20711279.8
(22) Date of filing: 06.03.2020
(51) Int. Cl.: A24F 40/50

(54) **VAPOUR PROVISION SYSTEM AND CORRESPONDING METHOD**
DAMPFBEREITSTELLUNGSSYSTEM UND ENTSPRECHENDES VERFAHREN
SYSTÈME DE FOURNITURE DE VAPEUR ET PROCÉDÉ CORRESPONDANT

(30) Priority: 08.03.2019 GB 201903137
(43) Date of publication of application: 12.01.2022
(73) Proprietor: Nicoventures Trading Limited, London WC2R 3LA (GB)
(72) Inventor: CHEN, Shixiang, LONDON WC2R 3LA (GB)
(74) Representative: Dainty, Katherine Louise
(86) International application number: PCT/GB2020/050549
(87) International publication number: WO 2020/183138

(56) References cited:
- US-A1- 2006 047 368
- US-A1- 2016 174 611
- US-A1- 2018 020 735

## Description

### Field

The present disclosure relates to vapour provision systems such as, but not limited to, nicotine delivery systems (e.g. electronic cigarettes and the like).

### Background

Electronic vapour provision systems such as electronic cigarettes (e-cigarettes) generally contain a vapour precursor material, such as a reservoir of a source liquid containing a formulation, typically but not necessarily including nicotine, or a solid material such as a tobacco-based product, from which a vapour is generated for inhalation by a user, for example through heat vaporisation. Thus, a vapour provision system will typically comprise a vapour generation chamber containing a vaporiser, e.g. a heating element, arranged to vaporise a portion of precursor material to generate a vapour in the vapour generation chamber. As a user inhales on the device and electrical power is supplied to the vaporiser, air is drawn into the device through inlet holes and into the vapour generation chamber where the air mixes with the vaporised precursor material and forms a condensation aerosol. There is a flow path between the vapour generation chamber and an opening in the mouthpiece so the incoming air drawn through the vapour generation chamber continues along the flow path to the mouthpiece opening, carrying some of the vapour / condensation aerosol with it, and out through the mouthpiece opening for inhalation by the user. Some electronic cigarettes may also include a flavour element in the flow path through the device to impart additional flavours. Such devices may sometimes be referred to as hybrid devices and the flavour element may, for example, include a portion of tobacco arranged in the air path between the vapour generation chamber and the mouthpiece so that vapour / condensation aerosol drawn through the devices passes through the portion of tobacco before exiting the mouthpiece for user inhalation.

Problems can arise with such vapour provision systems if the heating element becomes dry. This can happen, for example, because the supply of precursor material is running out. In that event, rapid over-heating in and around the heating element can occur. Having regard to typical operating conditions, the over-heated sections might be expected to quickly reach temperatures in the range 500 to 900°C. Not only does this rapid heating potentially damage components within the vapour provision system, it may also adversely affect the evaporation process of any residual precursor material. For example, the excess heat may cause the residual precursor material to decompose, for example through pyrolysis, which can potentially release unpleasant tasting substances into the air stream to be inhaled by a user. Examples of heater control devices and methods known from prior art are: US 2018/020735 A1, which shows a vapour provision system, wherein an initial resistance value is measured before the start of a puff and a subsequent electrical resistance is measured after starting a puff. The subsequent value is then compared to a maximum and a minimum threshold value, and an adverse condition is detected if the value is outside said thresholds. In US 2018/020735 A1 a fault condition is therefore detected based on resistance measurement of the heater.

US 2006/047368 A1, which shows a vapour provision system, wherein an operation is stopped in case a measured resistance exceeds a user-specified threshold.

US 2016/174611 A1, wherein a baseline resistance is measured after cooling down. This baseline resistance is used to define a target resistance, and therefore a target temperature of the resistive heater.

### Summary

In accordance with some embodiments described herein, there is provided a vapour provision system comprising:
a heating element for generating a vapour from a vapour precursor material; and
control circuitry configured to provide power for the heating element for performing a heating operation to generate the vapour and to compare a measurement of a resistance value for the heating element for the heating operation with a predetermined threshold resistance value for the heating element for use in detecting a fault condition, wherein the control circuitry is further configured to:
   monitor the resistance of the heating element during at least one heating operation of the heating element to determine a plurality of monitored resistance values over a period of time;
   compare each of the plurality of monitored resistance values with the predetermined threshold resistance value; and
   detect a fault condition for the heating element based on the comparison of the plurality of monitored resistance values with the predetermined threshold resistance value, wherein the control circuitry is configured to detect said fault condition for the heating element in the event a plurality of the monitored resistance values exceed the predetermined threshold resistance value during the period of time.

In accordance with some embodiments described herein, there is provided control circuitry, for use in a vapour provision system for generating a vapour from a vapour precursor material, wherein the control circuitry is operable to provide power for use in performing a heating operation in the vapour provision system, and operable to compare a measurement of a resistance value for the heating operation with a predetermined threshold resistance value for use in detecting a fault condition, wherein the control circuitry is further configured to:
monitor the resistance of the heating element during at least one heating operation of the heating element to determine a plurality of monitored resistance values over a period of time;
compare each of the plurality of monitored resistance values with the predetermined threshold resistance value; and
detect a fault condition for the heating element based on the comparison of the plurality of monitored resistance values with the predetermined threshold resistance value, wherein the control circuitry is configured to detect said fault condition for the heating element in the event a plurality of the monitored resistance values exceed the predetermined threshold resistance value during the period of time.

In accordance with some embodiments described herein, there is provided a method of operating control circuitry in a vapour provision system, the vapour provision system comprising a heating element for generating a vapour from a vapour precursor material, wherein the control circuitry is configured to provide power for the heating element for performing a heating operation to generate the vapour and to compare a measurement of a resistance value for the heating element for a heating operation with a predetermined threshold resistance value for the heating element for use in detecting a fault condition during the heating operation; wherein the method comprises the control circuitry:
monitoring the resistance of the heating element during at least one heating operation of the heating element to determine a plurality of monitored resistance values over a period of time;
comparing each of the plurality of monitored resistance values with the predetermined threshold resistance value; and
detecting a fault condition for the heating element based on the comparison of the plurality of monitored resistance values with the predetermined threshold resistance value, wherein the fault condition for the heating element is detected in the event a plurality of the monitored resistance values exceed the predetermined threshold resistance value during the period of time.

### Brief Description of the Drawings

Embodiments of the invention will now be described, by way of example only, with reference to the accompanying drawings, in which:
Figure 1 represents in highly schematic cross-section a vapour provision system in accordance with certain embodiments of the disclosure; and
Figure 2 is a flow diagram representing some operating steps for the vapour provision system of Figure 1 in accordance with certain embodiments of the disclosure;
Figure 3 is a flow diagram representing other operating steps for the vapour provision system of Figure 1 in accordance with certain embodiments of the disclosure; and
Figure 4 is a timeline relating to some of the operating steps for the vapour provision system of Figure 1 in accordance with certain embodiments of the disclosure.

### Detailed Description

Aspects and features of certain examples and embodiments are discussed / described herein. Some aspects and features of certain examples and embodiments may be implemented conventionally and these are not discussed / described in detail in the interests of brevity. It will thus be appreciated that aspects and features of apparatus and methods discussed herein which are not described in detail may be implemented in accordance with any conventional techniques for implementing such aspects and features.

The present disclosure relates to vapour provision systems, which may also be referred to as aerosol provision systems, such as e-cigarettes, including hybrid devices. Throughout the following description the term "e-cigarette" or "electronic cigarette" may sometimes be used, but it will be appreciated this term may be used interchangeably with vapour provision system / device and electronic vapour provision system / device. Furthermore, and as is common in the technical field, the terms "vapour" and "aerosol", and related terms such as "vaporise", "volatilise" and "aerosolise", may generally be used interchangeably.

Vapour provision systems (e-cigarettes) often, though not always, comprise a modular assembly including both a reusable part and a replaceable (disposable) cartridge part. Often the replaceable cartridge part will com prise the vapour precursor material and the vaporiser and the reusable part will comprise the power supply (e.g. rechargeable battery), activation mechanism (e.g. button or puff sensor), and control circuitry. However, it will be appreciated these different parts may also comprise further elements depending on functionality. For example, for a hybrid device the cartridge part may also com prise the additional flavour element, e.g. a portion of tobacco, provided as an insert ("pod"). In such cases the flavour element insert may itself be removable from the disposable cartridge part so it can be replaced separately from the cartridge, for example to change flavour or because the usable lifetime of the flavour element insert is less than the usable lifetime of the vapour generating components of the cartridge. The reusable device part will often also comprise additional components, such as a user interface for receiving user input and displaying operating status characteristics.

In some embodiments, the substance to be delivered by the vapour/aerosol provision system may be an aerosolisable material which may comprise an active constituent, a carrier constituent and optionally one or more other functional constituents.

The active constituent may comprise one or more physiologically and/or olfactory active constituents which are included in the aerosolisable material in order to achieve a physiological and/or olfactory response in the user. The active constituent may for example be selected from nutraceuticals, nootropics, and psychoactives. The active constituent may be naturally occurring or synthetically obtained. The active constituent may com prise for example nicotine, caffeine, taurine, theine, a vitamin such as B6 or B12 or C, melatonin, a cannabinoid, or a constituent, derivative, or combinations thereof. The active constituent may comprise a constituent, derivative or extract of tobacco or of another botanical. In some embodiments, the active constituent is a physiologically active constituent and may be selected from nicotine, nicotine salts (e.g. nicotine ditartrate/nicotine bitartrate), nicotine-free tobacco substitutes, other alkaloids such as caffeine, or mixtures thereof.

In some embodiments, the active constituent is an olfactory active constituent and may be selected from a "flavour" and/or "flavourant" which, where local regulations permit, may be used to create a desired taste, aroma or other somatosensorial sensation in a product for adult consumers. In some instances such constituents may be referred to as flavours, flavourants, cooling agents, heating agents, and/or sweetening agents. They may include naturally occurring flavour materials, botanicals, extracts of botanicals, synthetically obtained materials, or combinations thereof (e.g., tobacco, cannabis, licorice (liquorice), hydrangea, eugenol, Japanese white bark magnolia leaf, chamomile, fenugreek, clove, maple, matcha, menthol, Japanese mint, aniseed (anise), cinnamon, turmeric, Indian spices, Asian spices, herb, wintergreen, cherry, berry, red berry, cranberry, peach, apple, orange, mango, clementine, lemon, lime, tropical fruit, papaya, rhubarb, grape, durian, dragon fruit, cucumber, blueberry, mulberry, citrus fruits, Drambuie, bourbon, scotch, whiskey, gin, tequila, rum, spearmint, peppermint, lavender, aloe vera, cardamom, celery, cascarilla, nutmeg, sandalwood, bergamot, geranium, khat, naswar, betel, shisha, pine, honey essence, rose oil, vanilla, lemon oil, orange oil, orange blossom, cherry blossom, cassia, caraway, cognac, jasmine, ylang-ylang, sage, fennel, wasabi, piment, ginger, coriander, coffee, hemp, a mint oil from any species of the genus Mentha, eucalyptus, star anise, cocoa, lemongrass, rooibos, flax, ginkgo biloba, hazel, hibiscus, laurel, mate, orange skin, rose, tea such as green tea or black tea, thyme, juniper, elderflower, basil, bay leaves, cumin, oregano, paprika, rosemary, saffron, lemon peel, mint, beefsteak plant, curcuma, cilantro, myrtle, cassis, valerian, pimento, mace, damien, marjoram, olive, lemon balm, lemon basil, chive, carvi, verbena, tarragon, limonene, thymol, camphene), flavour enhancers, bitterness receptor site blockers, sensorial receptor site activators or stimulators, sugars and/or sugar substitutes (e.g., sucralose, acesulfame potassium, aspartame, saccharine, cyclamates, lactose, sucrose, glucose, fructose, sorbitol, or mannitol), and other additives such as charcoal, chlorophyll, minerals, botanicals, or breath freshening agents. They may be imitation, synthetic or natural ingredients or blends thereof. They may be in any suitable form, for example, liquid such as an oil, solid such as a powder, or gasone or more of extracts (e.g., licorice, hydrangea, Japanese white bark magnolia leaf, chamomile, fenugreek, clove, menthol, Japanese mint, aniseed, cinnamon, herb, wintergreen, cherry, berry, peach, apple, Drambuie, bourbon, scotch, whiskey, spearmint, peppermint, lavender, cardamom, celery, cascarilla, nutmeg, sandalwood, bergamot, geranium, honey essence, rose oil, vanilla, lemon oil, orange oil, cassia, caraway, cognac, jasmine, ylang-ylang, sage, fennel, piment, ginger, anise, coriander, coffee, or a mint oil from any species of the genus Mentha), flavour enhancers, bitterness receptor site blockers, sensorial receptor site activators or stimulators, sugars and/or sugar substitutes (e.g., sucralose, acesulfame potassium, aspartame, saccharine, cyclamates, lactose, sucrose, glucose, fructose, sorbitol, or mannitol), and other additives such as charcoal, chlorophyll, minerals, botanicals, or breath freshening agents. They may be imitation, synthetic or natural ingredients or blends thereof. They may be in any suitable form, for example, oil, liquid, or powder.

In some embodiments, the flavour comprises menthol, spearmint and/or peppermint. In some embodiments, the flavour comprises flavour components of cucumber, blueberry, citrus fruits and/or redberry. In some embodiments, the flavour comprises eugenol. In some embodiments, the flavour comprises flavour components extracted from tobacco. In some embodiments, the flavour may comprise a sensate, which is intended to achieve a somatosensorial sensation which are usually chemically induced and perceived by the stimulation of the fifth cranial nerve (trigeminal nerve), in addition to or in place of aroma or taste nerves, and these may include agents providing heating, cooling, tingling, numbing effect. A suitable heat effect agent may be, but is not limited to, vanillyl ethyl ether and a suitable cooling agent may be, but not limited to eucalyptol, WS-3.

The carrier constituent may comprise one or more constituents capable of forming an aerosol. In some embodiments, the carrier constituent may comprise one or more of glycerine, glycerol, propylene glycol, diethylene glycol, triethylene glycol, tetraethylene glycol, 1,3-butylene glycol, erythritol, meso-Erythritol, ethyl vanillate, ethyl laurate, a diethyl suberate, triethyl citrate, triacetin, a diacetin mixture, benzyl benzoate, benzyl phenyl acetate, tributyrin, lauryl acetate, lauric acid, myristic acid, and propylene carbonate.

The one or more other functional constituents may comprise one or more of pH regulators, colouring agents, preservatives, binders, fillers, stabilizers, and/or antioxidants.

For modular devices a cartridge and control unit are electrically and mechanically coupled together for use, for example using a screw thread, latching or bayonet fixing with appropriately engaging electrical contacts. When the vapour precursor material in a cartridge is exhausted, or the user wishes to switch to a different cartridge having a different vapour precursor material, a cartridge may be removed from the control unit and a replacement cartridge attached in its place. Devices conforming to this type of two-part modular configuration may generally be referred to as two-part devices or multi-part devices.

It is relatively common for electronic cigarettes, including multi-part devices, to have a generally elongate shape and, for the sake of providing a concrete example, certain embodiments of the disclosure described herein will be taken to comprise a generally elongate multi-part device employing disposable cartridges with a tobacco pod insert. However, it will be appreciated the underlying principles described herein may equally be adopted for different electronic cigarette configurations, for example single-part devices or modular devices comprising more than two parts, refillable devices and single-use disposable devices, and non-hybrid devices which do not have an additional flavour element, as well as devices conforming to other overall shapes, for example based on so-called box-mod high performance devices that typically have a more box-like shape. More generally, it will be appreciated certain embodiments of the disclosure are based on electronic cigarettes that are configured to provide activation functionality in accordance with the principles described herein, and the specific constructional aspects of electronic cigarette configured to provide the described activation functionality are not of primary significance.

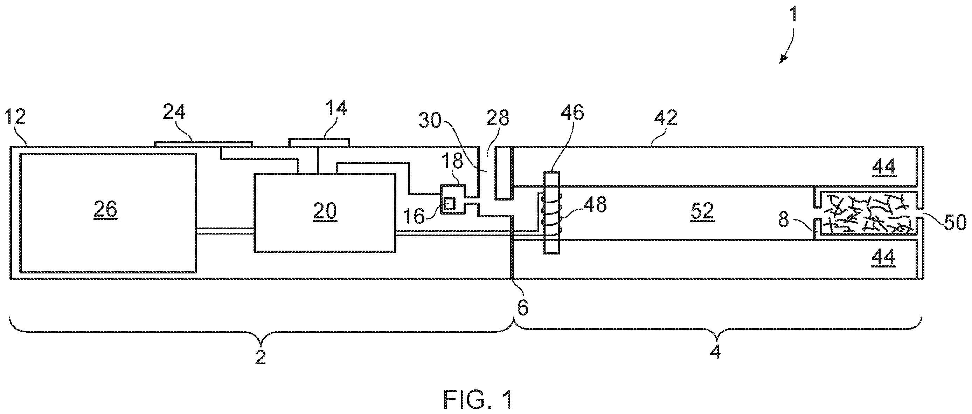

Figure 1 is a cross-sectional view through an example e-cigarette 1 in accordance with certain embodiments of the disclosure. The e-cigarette 1 comprises two main components, namely a reusable part 2 and a replaceable / disposable cartridge part 4. In this specific example the e-cigarette 1 is assumed to be a hybrid device with the cartridge part 4 including a removable insert 8 comprising an insert housing containing a portion of shredded tobacco. However, the fact this example is a hybrid device is not in itself directly significant to the device activation functionality as described further herein.

In normal use the reusable part 2 and the cartridge part 4 are releasably coupled together at an interface 6. When the cartridge part is exhausted or the user simply wishes to switch to a different cartridge part, the cartridge part may be removed from the reusable part and a replacement cartridge part attached to the reusable part in its place. The interface 6 provides a structural, electrical and air path connection between the two parts and may be established in accordance with conventional techniques, for example based around a screw thread, latch mechanism, or bayonet fixing with appropriately arranged electrical contacts and openings for establishing the electrical connection and air path between the two parts as appropriate. The specific manner by which the cartridge part 4 mechanically mounts to the reusable part 2 is not significant to the principles described herein, but for the sake of a concrete example is assumed here to comprise a latching mechanism, for example with a portion of the cartridge being received in a corresponding receptacle in the reusable part with cooperating latch engaging elements (not represented in Figure 1). It will also be appreciated the interface 6 in some implementations may not support an electrical connection between the respective parts. For example, in some implementations a vaporiser may be provided in the reusable part rather than in the cartridge part, or the transfer of electrical power from the reusable part to the cartridge part may be wireless (e.g. based on electromagnetic induction), so that an electrical connection between the reusable part and the cartridge part is not needed.

The cartridge part 4 may in accordance with certain embodiments of the disclosure be broadly conventional. In Figure 1, the cartridge part 4 comprises a cartridge housing 42 formed of a plastics material. The cartridge housing 42 supports other components of the cartridge part and provides the mechanical interface 6 with the reusable part 2. The cartridge housing is generally circularly symmetric about a longitudinal axis along which the cartridge part couples to the reusable part 2. In this example the cartridge part has a length of around 4 cm and a diameter of around 1.5 cm. However, it will be appreciated the specific geometry, and more generally the overall shapes and materials used, may be different in different implementations.

Within the cartridge housing 42 is a reservoir 44 that contains liquid vapour precursor material. The liquid vapour precursor material may be conventional, and may be referred to as e-liquid. The liquid reservoir 44 in this example has an annular shape with an outer wall defined by the cartridge housing 42 and an inner wall that defines an air path 52 through the cartridge part 4. The reservoir 44 is closed at each end with end walls to contain the e-liquid. The reservoir 44 may be formed in accordance with conventional techniques, for example it may comprise a plastics material and be integrally moulded with the cartridge housing 42.

The flavour element insert (tobacco pod) 8 in this example is inserted into an open end of air path 52 opposite to the end of the cartridge 4 which couples to the control unit 2 and is retained by a friction fit. The housing for the flavour element insert 8 includes a collar that abuts the end of the cartridge housing 42 to prevent over insertion. The housing for the flavour element insert 8 also includes an opening at each end to allow air drawn along the air path 52 during use to pass through the flavour element insert 8 and so pick up flavours from the flavourant within (tobacco in this example) before exiting the cartridge 4 though a mouthpiece outlet 50 for user inhalation.

The cartridge part further comprises a wick46 and a heating element (vaporiser) 48 located towards an end of the reservoir 44 opposite to the mouthpiece outlet 50. In this example the wick 46 extends transversely across the cartridge air path 52 with its ends extending into the reservoir 44 of e-liquid through openings in the inner wall of the reservoir 44. The openings in the inner wall of the reservoir are sized to broadly match the dimensions of the wick46 to provide a reasonable seal against leakage from the liquid reservoir into the cartridge air path without unduly compressing the wick, which may be detrimental to its fluid transfer performance.

The wick 46 and heating element 48 are arranged in the cartridge air path 52 such that a region of the cartridge air path 52 around the wick 46 and heating element 48 in effect defines a vaporisation region for the cartridge part. E-liquid in the reservoir 44 infiltrates the wick 46 through the ends of the wick extending into the reservoir 44 and is drawn along the wick by surface tension / capillary action (i.e. wicking). The heating element 48 in this example comprises an electrically resistive wire coiled around the wick 46. In this example the heating element 48 comprises a nickel chrome alloy (Cr20Ni80) wire and the wick 46 comprises a glass fibre bundle, but it will be appreciated the specific vaporiser configuration is not significant to the principles described herein. In use electrical power may be supplied to the heating element 48 to vaporise an amount of e-liquid (vapour precursor material) drawn to the vicinity of the heating element 48 by the wick46. Vaporised e-liquid may then become entrained in air drawn along the cartridge air path from the vaporisation region through the flavour element insert 8 and out the mouthpiece outlet 50 for user inhalation.

The rate at which e-liquid is vaporised by the vaporiser (heating element) 48 will depend on the amount (level) of power supplied to the heating element 48 during use. Thus electrical power can be applied to the heating element to selectively generate vapour from the e-liquid in the cartridge part 4, and furthermore, the rate of vapour generation can be changed by changing the amount of power supplied to the heating element 48, for example through pulse width and/or frequency modulation techniques.

The reusable part 2 comprises an outer housing 12 with an opening that defines an air inlet 28 for the e-cigarette, a battery 26 for providing operating power for the electronic cigarette, control circuitry 20 for controlling and monitoring the operation of the electronic cigarette, a user input button 14, an inhalation sensor (puff detector) 16, which in this example comprises a pressure sensor located in a pressure sensor chamber 18, and a visual display 24.

The outer housing 12 may be formed, for example, from a plastics or metallic material and in this example has a circular cross-section generally conforming to the shape and size of the cartridge part 4 so as to provide a smooth transition between the two parts at the interface 6. In this example, the reusable part has a length of around 8 cm so the overall length of the e-cigarette when the cartridge part and reusable part are coupled together is around 12 cm. However, and as already noted, it will be appreciated that the overall shape and scale of an electronic cigarette implementing an embodiment of the disclosure is not significant to the principles described herein.

The air inlet 28 connects to an air path 30 through the reusable part 2. The reusable part air path 30 in turn connects to the cartridge air path 52 across the interface 6 when the reusable part 2 and cartridge part 4 are connected together. The pressure sensor chamber 18 containing the pressure sensor 16 is in fluid communication with the air path 30 in the reusable part 2 (i.e. the pressure sensor chamber 18 branches off from the air path 30 in the reusable part 2). Thus, when a user inhales on the mouthpiece opening 50, there is a drop in pressure in the pressure sensor chamber 18 that may be detected by the pressure sensor 16 and also air is drawn in through the air inlet 28, along the reusable part air path 30, across the interface 6, through the vapour generation region in the vicinity of the atomiser 48 (where vaporised e-liquid becomes entrained in the air flow when the vaporiser is active), along the cartridge air path 52, and out through the mouthpiece opening 50 for user inhalation.

The battery 26 in this example is rechargeable and may be of a conventional type, for example of the kind normally used in electronic cigarettes and other applications requiring provision of relatively high currents over relatively short periods. The battery 26 may be recharged through a charging connector in the reusable part housing 12, for example a USB connector.

The user input button 14 in this example is a conventional mechanical button, for example comprising a spring mounted component which may be pressed by a user to establish an electrical contact. In this regard, the input button may be considered to provide a manual input mechanism for the terminal device, but the specific manner in which the button is implemented is not significant. For example, different forms of mechanical button or touch-sensitive button (e.g. based on capacitive or optical sensing techniques) may be used in other implementations. The specific manner in which the button is implemented may, for example, be selected having regard to a desired aesthetic appearance.

The display 24 is provided to give a user with a visual indication of various characteristics associated with the electronic cigarette, for example current power setting information, remaining battery power, and so forth. The display may be implemented in various ways. In this example the display 24 comprises a conventional pixilated LCD screen that may be driven to display the desired information in accordance with conventional techniques. In other implementations the display may comprise one or more discrete indicators, for example LEDs, that are arranged to display the desired information, for example through particular colours and / or flash sequences. More generally, the manner in which the display is provided and information is displayed to a user using the display is not significant to the principles described herein. Some embodiments may not include a visual display and may include other means for providing a user with information relating to operating characteristics of the electronic cigarette, for example using audio signalling or haptic feedback, or may not include any means for providing a user with information relating to operating characteristics of the electronic cigarette.

The control circuitry 20 is suitably configured / programmed to control the operation of the electronic cigarette to provide functionality in accordance with embodiments of the disclosure as described further herein, as well as for providing conventional operating functions of the electronic cigarette in line with the established techniques for controlling such devices. The control circuitry (processor circuitry) 20 may be considered to logically comprise various subunits / circuitry elements associated with different aspects of the electronic cigarette's operation in accordance with the principles described herein and other conventional operating aspects of electronic cigarettes, such as display driving circuitry and user input detection. It will be appreciated the functionality of the control circuitry 20 can be provided in various different ways, for example using one or more suitably programmed programmable computer(s) and / or one or more suitably configured application-specific integrated circuit(s) / circuitry / chip(s) / chipset(s) configured to provide the desired functionality.

Thus the vapour provision system 1 comprises a user input button 14 and an inhalation sensor 16. In accordance with certain embodiments of the disclosure the control circuitry 20 is configured to receive signalling from the inhalation sensor 16 and to use this signalling to determine if a user is inhaling in the electronic cigarette and also to receive signalling from the input button 14 and to use this signalling to determine if a user is pressing (i.e. activating) the input button. These aspects of the operation of the electronic cigarette (i.e. puff detection and button press detection) may in themselves be performed in accordance with established techniques (for example using conventional inhalation sensor and inhalation sensor signal processing techniques and using conventional input button and input button signal processing techniques).

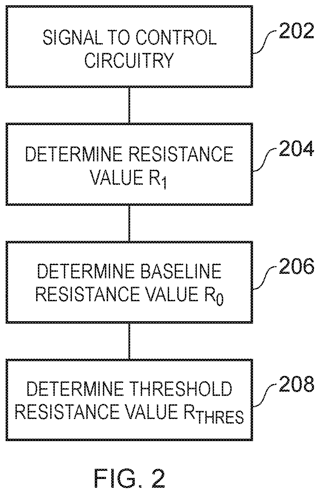

With reference to Figure 2, the control circuitry 20 is configured to power the heating element 48 in response to a signal from either the user input button 14 and/or the inhalation sensor 16 (step 202 in Figure 2). In the event of such a signal being received, the control circuitry 20 provides power to the heating element 48 for performing a heating operation to generate an aerosol/vapour from the vapour precursor material contained within the vapour provision system. Accordingly, at the start of a first heating operation, the control circuitry 20 is configured to measure a resistance value R₁ for the heating element 48 (step 204). The resistance value is measured at a particular time within the heating operation shortly before the heating element 48 is heated.

The control circuitry 20 then establishes a baseline resistance value R₀ based on the measured resistance value R₁ (step 206). The baseline resistance value R₀ is a reflection of the resistance, and thus the temperature, of the heating element 48, in a state when it is cold/unused.

Using the baseline resistance value R₀, the control circuitry 20 determines a threshold resistance value R_{Thres} (step 208) which is higher than the baseline resistance value R₀. The threshold resistance value R_{Thres} is indicative of a resistance for the heating element 48 whose corresponding temperature is too high. The value for this threshold resistance value will depend on the vapour provision system used. However, in some embodiments the threshold resistance value R_{Thres} is based on a predetermined multiple of the baseline resistance value R₀. One particular example is R_{Thres} = 2.2 x R₀. In some embodiments of vapour provision system, R_{Thres} may be in the region of 1100mOhm - 1500mOhm.

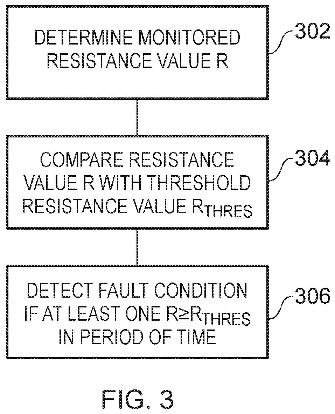

Following the determination of the threshold resistance value R_{Thres} for the heating element 48, with reference to Figure 3, the control circuitry 20 then monitors the resistance of the heating element during the heating operation to determine a monitored resistance value R (step 302). For each monitored resistance value R, the control circuitry 20 compares this resistance value R with the threshold resistance value R_{Thres} (step 304). In the case where one or more monitored resistance values R exceed the threshold resistance value R_{Thres}, that may be indicative of a fault condition for the heating element 48 (step 306). In such cases, an event may be triggered by the control circuitry 20, which may be an alarm or placing the vapour provision system into an 'off' or 'standby' state.

After the heating operation, the control circuitry 20 stops power being provided to the heating element 48, which causes the heating element to cool down, and then waits for a new signal from either the user input button 14 and/or the inhalation sensor 16 to begin a subsequent heating operation.

Upon a new signal being received, the control circuitry 20 operates in the same way as described above in relation to the previous heating operation, in that it monitors the resistance of the heating element during the heating operation to determine a monitored resistance value R, and then compares this resistance value R with the predetermined threshold resistance value R_{Thres}.

The control circuitry 20 is therefore configured to monitor the resistance of the heating element 48 during at least one heating operation of the heating element 48 to determine a plurality of monitored resistance values R over a period of time (step 302). For example, the control circuitry may be configured to monitor resistance by sampling the resistance of the heating element 48 at a rate of between 5 and 500 Hz, and preferably at around 200Hz. The control circuitry 20 is configured to compare each of the plurality of monitored resistance values R with the predetermined threshold resistance value R_{Thres} (step 304); and detect a fault condition for the heating element 48 based on the comparison of the plurality of monitored resistance values R with the predetermined threshold resistance value R_{Thres} (step 306).

In comparing each of the plurality of monitored resistance values R with the predetermined threshold resistance value R_{Thres} (step 304) as set out above, it is intended that each monitored resistance value R be immediately compared with the predetermined threshold resistance value R_{Thres} after the resistance value R has been determined, as opposed to performing the comparison of each of the plurality of monitored resistance values R with the predetermined threshold resistance value R_{Thres} only once all the plurality of monitored resistance values R have been determined. In that way, the detection of any fault condition can occur in a more timely fashion.

According to the invention, the control circuitry may be configured to detect a fault condition for the heating element 48 in the event a plurality of the monitored resistance values R exceed the predetermined threshold resistance value R_{Thres} during the period of time. In that way, by requiring a plurality of monitored resistance values R to exceed the predetermined threshold resistance value R_{Thres}, as opposed to just one monitored resistance value R exceeding the predetermined threshold resistance value R_{Thres}, this may serve to prevent a single rogue/erroneous monitored resistance value R from resulting in a detection of a fault condition for the heating element 48.

In some embodiments, the monitored resistance values R which exceed the predetermined threshold resistance value R_{Thres} may need to be consecutive monitored resistance values R. In other embodiments, the monitored resistance values R which exceed the predetermined threshold resistance value R_{Thres} may not be consecutive monitored resistance values R. For example, the monitored resistance values R which exceed the predetermined threshold resistance value R_{Thres} may be any consecutive or non-consecutive values recorded during a period of time.

In some embodiments, the plurality of the monitored resistance values which exceed the predetermined threshold resistance value may comprise at least two, or at least three, or more than three, monitored resistance values which exceed the predetermined threshold resistance value. By increasing the number of monitored resistance values which must exceed the predetermined threshold resistance value before the fault condition is detected, this decreases the likelihood of rogue/erroneous monitored resistance values R from resulting in a detection of a fault condition for the heating element 48.

In some embodiments, the period of time in which the control circuitry 20 is configured to monitor the resistance of the heating element 48 may be the duration of a heating operation of the heating element, the duration of a predetermined consecutive number of heating operations of the heating element, or the duration of a cumulative number of heating operations of the heating element (which may or may not be consecutive). In one particular embodiment, the predetermined consecutive number of heating operations of the heating element may be any positive integer number of consecutive heating operations of the heating element (e.g. ten heating operations).

In some embodiments, the period of time in which the control circuitry 20 is configured to monitor the resistance of the heating element 48 may comprise at least one of 3 seconds, 10 seconds, 30 seconds, 60 seconds, or 120 seconds. It will be appreciated that the period of time selected will vary depending on the application of the control circuitry to each type of heating element 48 and its surroundings. It will further be appreciated that such a period of time may cover a number of sequential heating operations of the heating element. In some examples, the control circuitry may be configured to continually monitor the resistance of the heating element between heating operations. In other examples, the control circuitry may be configured to pause the monitoring of the resistance of the heating element between heating operations, and to resume monitoring resistance of the heating element at the start of heating operations. The period of time may therefore comprise a continuous period of a time; or a plurality of smaller, separated, period of times which together form the period of time.

In some embodiments, the period of time in which the control circuitry 20 is configured to monitor the resistance of the heating element may correspond to the time taken to measure a predetermined number of the individual resistance values R. For example, in one embodiment, if the control circuitry 20 is configured to monitor the resistance of the heating element during a heating operation at a sample rate of 200Hz, then for a target of 5 seconds of monitoring, the period of time in which the control circuitry is configured to monitor the resistance of the heating element may correspond to the time taken to measure 1000 measurements for the resistance of the heating element.

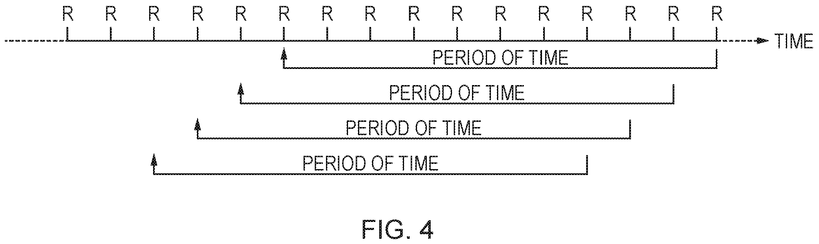

In some embodiments, as illustrated in Figure 4, the period of time in which the control circuitry 20 is configured to monitor the resistance of the heating element 48 may be a moving/rolling period of time, such that each determined monitored resistance value R comprises its own associated period of time. For instance, in an embodiment where the period of time comprises a predetermined number of seconds (e.g. ten seconds), for a given determined monitored resistance value R, the control circuitry would be configured to detect a fault condition if that determined monitored resistance value R, and any preceding determined monitored resistance value(s) R occurring within the period of time before the given determined monitored resistance value R was determined, exceed the predetermined threshold resistance value R_{Thres}.

As described in the above embodiments therefore, the control circuitry 20 may be configured to detect a fault condition for the heating element 48 in various different ways that help to reduce the likelihood of a fault condition being detected as a result of one or more rogue/erroneous monitored resistance values R being determined that are unusually high.

To that effect, one particular embodiment for the control circuitry 20 might include it determining a plurality of monitored resistance values occurring during a single heating operation of the heating element, and detecting a fault condition for the heating element in the event a plurality, as opposed to just one, of those monitored resistance values exceeds the predetermined threshold resistance value during that heating operation of the heating element.

According to the invention, the control circuitry 20 might determine a plurality of monitored resistance values occurring during a set period of time, and detect a fault condition for the heating element in the event a plurality of those monitored resistance values exceed the predetermined threshold resistance value during that period of time (e.g. a fault being detected if five monitored resistance values exceed the predetermined threshold resistance value in ten minutes, or preferably in 5 minutes).

In another particular embodiment, the control circuitry 20 might determine a plurality of monitored resistance values occurring during a predetermined consecutive number of heating operations of the heating element, and detect a fault condition for the heating element in the event a plurality of those monitored resistance values exceed the predetermined threshold resistance value during the predetermined consecutive number of heating operations of the heating element (e.g. a fault being detected if three monitored resistance values exceed the predetermined threshold resistance value in the preceding ten heating operations).

Thus, as discussed above, by virtue of the control circuitry 20 requiring a plurality of the monitored resistance values, as opposed to just one monitored resistance value, to exceed the predetermined threshold resistance value before a fault condition is detected, these embodiments of the disclosure provide a vapour provision system which mitigates against detecting a fault condition for the heating element 48 as a result of one or more false-positive/erroneous monitored resistance values R being determined that are unusually high. In terms of the system used by the control circuitry 20 to monitor the resistance of the heating element 48, the process of measuring the resistance of the heating element 48 may be performed in accordance with conventional resistance measurement techniques. That is to say, the control circuitry 20 may comprise a resistance-measuring component that is based on established techniques for measuring resistance (or a corresponding electrical parameter).

In accordance with some embodiments of the disclosure, the vapour precursor material may be located in the cartridge part 4, which is detachable from the second reusable part 2 containing the heating element 48 and the control circuitry 20.

While the above-described embodiments have in some respects focussed on some specific example vapour provision systems, it will be appreciated the same principles can be applied for vapour provision systems using other technologies. That is to say, the specific manner in which various aspects of the vapour provision system function are not directly relevant to the principles underlying the examples described herein.

For example, whereas the above-described embodiments have primarily focused on devices having an electrical heater based vaporiser for heating a liquid vapour precursor material, the same principles may be adopted in accordance with vaporisers based on other technologies, for example piezoelectric vibrator based vaporisers or optical heating vaporisers, and also devices based on other vapour precursor materials, for example solid materials, such as plant derived materials, such as tobacco derivative materials, or other forms of vapour precursor materials, such as gel, paste or foam based vapour precursor materials.

Furthermore, and as already noted, it will be appreciated the above-described approaches in connection with an electronic cigarette may be implemented in cigarettes having a different overall construction than that represented in Figure 1. For example, the same principles may be adopted in an electronic cigarette which does not com prise a two-part modular construction, but which instead comprises a single-part device, for example a disposable (i.e. non-rechargeable and non-refillable) device. Furthermore, in some implementations of a modular device, the arrangement of components may be different. For example, in some implementations the control unit may also comprise the vaporiser with a replaceable cartridge providing a source of vapour precursor material for the vaporiser to use to generate vapour. Furthermore still, whereas in the above-described examples the electronic cigarette 1 includes a flavour insert 8, other examples implementations may not include such an additional flavour element.

In order to address various issues and advance the art, this disclosure shows by way of illustration various embodiments in which the claimed invention(s) may be practiced. The advantages and features of the disclosure are of a representative sample of embodiments only, and are not exhaustive and / or exclusive. They are presented only to assist in understanding and to teach the claimed invention(s). It is to be understood that advantages, embodiments, examples, functions, features, structures, and / or other aspects of the disclosure are not to be considered limitations on the disclosure as defined by the claims.

## Claims

1. A vapour provision system (1) comprising:
a heating element (48) for generating a vapour from a vapour precursor material; and
control circuitry (20) configured to provide power for the heating element for performing a heating operation to generate the vapour and to compare a measurement of a resistance value for the heating element for the heating operation with a predetermined threshold resistance value for the heating element for use in detecting a fault condition, wherein the control circuitry is further configured to:
monitor the resistance of the heating element during at least one heating operation of the heating element to determine a plurality of monitored resistance values over a period of time;
compare each of the plurality of monitored resistance values with the predetermined threshold resistance value; and
detect a fault condition for the heating element based on the comparison of the plurality of monitored resistance values with the predetermined threshold resistance value, wherein the control circuitry is configured to detect said fault condition for the heating element in the event a plurality of the monitored resistance values exceed the predetermined threshold resistance value during the period of time.

2. A vapour provision system according to claim 1, wherein the plurality of the monitored resistance values which exceed the predetermined threshold resistance value are consecutive.

3. A vapour provision system according to claim 1 or 2, wherein the plurality of the monitored resistance values which exceed the predetermined threshold resistance value comprises at least two monitored resistance values which exceed the predetermined threshold resistance value.

4. A vapour provision system according to claim 3, wherein the plurality of the monitored resistance values which exceed the predetermined threshold resistance value comprises at least three monitored resistance values which exceed the predetermined threshold resistance value.

5. A vapour provision system according to any of claim 1 to 4, wherein the period of time is the duration of a heating operation of the heating element (48).

6. A vapour provision system according to any of claim 1 to 4, wherein the period of time is the duration of a predetermined consecutive number of heating operations of the heating element (48).

7. A vapour provision system according to claim 6, wherein the predetermined consecutive number of heating operations of the heating element is ten consecutive heating operations of the heating element (48).

8. A vapour provision system according to any of claim 1 to 4, wherein the period of time comprises at least one of 10 seconds, 30 seconds, 60 seconds, or 120 seconds.

9. A vapour provision system according to any of claim 1 to 8, wherein the control circuitry (20) is configured, for each monitored resistance value, to detect a fault condition if the determined monitored resistance value, and at least one preceding determined monitored resistance value occurring within the period of time before the given determined monitored resistance value was determined, exceeds the predetermined threshold resistance value

10. A vapour provision system according to any of claim 1 to 9, wherein the control circuitry (20) is further configured to determine a baseline resistance value for the heating element by making a measurement of a first resistance value for the heating element, wherein the threshold resistance value is determined based on the baseline resistance value.

11. A vapour provision system according to claim 10, wherein the threshold resistance value is a predetermined multiple of the baseline resistance value.

12. A vapour provision system according to any of claim 1 to 11, wherein the system comprises an inhalation sensor (16), and wherein the control circuitry (20) is configured to provide power for the heating element (48) for a heating operation in response to a signal from the inhalation sensor which is indicative of a user inhaling on the vapour provision system.

13. A control circuitry (20), for use in a vapour provision system (1) for generating a vapour from a vapour precursor material, wherein the control circuitry is operable to provide power for use in performing a heating operation in the vapour provision system, and operable to compare a measurement of a resistance value for the heating operation with a predetermined threshold resistance value for use in detecting a fault condition, wherein the control circuitry is further configured to:
monitor the resistance of the heating element during at least one heating operation of the heating element (48) to determine a plurality of monitored resistance values over a period of time;
compare each of the plurality of monitored resistance values with the predetermined threshold resistance value; and
detect a fault condition for the heating element based on the comparison of the plurality of monitored resistance values with the predetermined threshold resistance value, wherein the control circuitry is configured to detect said fault condition for the heating element in the event a plurality of the monitored resistance values exceed the predetermined threshold resistance value during the period of time.

14. A method of operating control circuitry (20) in a vapour provision system (1), the vapour provision system comprising a heating element (48) for generating a vapour from a vapour precursor material, wherein the control circuitry is configured to provide power for the heating element for performing a heating operation to generate the vapour and to compare a measurement of a resistance value for the heating element for a heating operation with a predetermined threshold resistance value for the heating element for use in detecting a fault condition during the heating operation; wherein the method comprises the control circuitry:
monitoring the resistance of the heating element during at least one heating operation of the heating element to determine a plurality of monitored resistance values over a period of time;
comparing (304) each of the plurality of monitored resistance values with the predetermined threshold resistance value; and
detecting a fault condition (306) for the heating element based on the comparison of the plurality of monitored resistance values with the predetermined threshold resistance value, wherein the fault condition for the heating element is detected in the event a plurality of the monitored resistance values exceed the predetermined threshold resistance value during the period of time.

## Patentansprüche

1. Dampfbereitstellungssystem (1), umfassend:
ein Heizelement (48) zum Erzeugen eines Dampfes aus einem Dampfvorläufermaterial; und
Steuerschaltung (20), die konfiguriert ist, um Leistung für das Heizelement bereitzustellen, um einen Heizvorgang auszuführen, um den Dampf zu erzeugen und um eine Messung eines Widerstandswertes für das Heizelement für den Heizvorgang mit einem vorbestimmten Schwellenwiderstandswert für das Heizelement zur Verwendung beim Erfassen eines Fehlerzustands zu vergleichen,
wobei die Steuerschaltung ferner zu Folgendem konfiguriert ist:
Überwachen des Widerstands des Heizelements während zumindest eines Heizvorgangs des Heizelements, um eine Vielzahl von überwachten Widerstandswerten über einen Zeitraum zu bestimmen;
Vergleichen von jedem aus der Vielzahl von überwachten Widerstandswerten mit dem vorbestimmten Schwellenwiderstandswert, und
Erfassen eines Fehlerzustands für das Heizelement basierend auf dem Vergleich der Vielzahl von überwachten Widerstandswerten mit dem vorbestimmten Schwellenwiderstandswert, wobei die Steuerschaltung konfiguriert ist, um den Fehlerzustand für das Heizelement in dem Fall zu erfassen, dass eine Vielzahl der überwachten Widerstandswerte den vorbestimmten Schwellenwiderstandswert während des Zeitraums überschreitet.

2. Dampfbereitstellungssystem nach Anspruch 1, wobei die Vielzahl der überwachten Widerstandswerte, die den vorbestimmten Schwellenwiderstandswert überschreitet, aufeinanderfolgend ist.

3. Dampfbereitstellungssystem nach Anspruch 1 oder 2, wobei die Vielzahl der überwachten Widerstandswerte, die den vorbestimmten Schwellenwiderstandswert überschreitet, zumindest zwei überwachte Widerstandswerte umfasst, die den vorbestimmten Schwellenwiderstandswert überschreiten.

4. Dampfbereitstellungssystem nach Anspruch 3, wobei die Vielzahl der überwachten Widerstandswerte, die den vorbestimmten Schwellenwiderstandswert überschreitet, zumindest drei überwachte Widerstandswerte umfasst, die den vorbestimmten Schwellenwiderstandswert überschreiten.

5. Dampfbereitstellungssystem nach einem der Ansprüche 1 bis 4, wobei der Zeitraum die Dauer eines Heizvorgangs des Heizelements (48) ist.

6. Dampfbereitstellungssystem nach einem der Ansprüche 1 bis 4, wobei der Zeitraum die Dauer einer vorbestimmten aufeinanderfolgenden Anzahl an Heizvorgängen des Heizelements (48) ist.

7. Dampfbereitstellungssystem nach Anspruch 6, wobei die vorbestimmte aufeinanderfolgende Anzahl an Heizvorgängen des Heizelements zehn aufeinanderfolgende Heizvorgänge des Heizelements (48) ist.

8. Dampfbereitstellungssystem nach einem der Ansprüche 1 bis 4, wobei der Zeitraum zumindest eines von 10 Sekunden, 30 Sekunden, 60 Sekunden oder 120 Sekunden umfasst.

9. Dampfbereitstellungssystem nach einem der Ansprüche 1 bis 8, wobei die Steuerschaltung (20) konfiguriert ist, um für jeden überwachten Widerstandswert einen Fehlerzustand zu erfassen, wenn der bestimmte überwachte Widerstandswert und zumindest ein vorhergehender bestimmter überwachter Widerstandswert, der innerhalb des Zeitraums auftritt, bevor der gegebene bestimmte überwachte Widerstandswert bestimmt wurde, den vorbestimmten Schwellenwiderstandswert überschreitet.

10. Dampfbereitstellungssystem nach einem der Ansprüche 1 bis 9, wobei die Steuerschaltung (20) ferner konfiguriert ist, um einen Basiswiderstandswert für das Heizelement zu bestimmen, indem eine Messung eines ersten Widerstandswertes für das Heizelement durchgeführt wird, wobei der Schwellenwiderstandswert basierend auf dem Basiswiderstandswert bestimmt wird.

11. Dampfbereitstellungssystem nach Anspruch 10, wobei der Schwellenwiderstandswert ein vorbestimmtes Vielfaches des Basiswiderstandswertes ist.

12. Dampfbereitstellungssystem nach einem der Ansprüche 1 bis 11, wobei das System einen Inhalationssensor (16) umfasst und wobei die Steuerschaltung (20) konfiguriert ist, um Leistung für das Heizelement (48) für einen Heizvorgang als Reaktion auf ein Signal von dem Inhalationssensor bereitzustellen, das angibt, dass ein Benutzer an dem Dampfbereitstellungssystem inhaliert.

13. Steuerschaltung (20) zur Verwendung in einem Dampfbereitstellungssystem (1) zum Erzeugen eines Dampfes aus einem Dampfvorläufermaterial, wobei die Steuerschaltung bedienbar ist, um Leistung zur Verwendung beim Ausführen eines Heizvorgangs in dem Dampfbereitstellungssystem bereitzustellen, und bedienbar, um eine Messung eines Widerstandswertes für den Heizvorgang mit einem vorbestimmten Schwellenwiderstandswert zur Verwendung beim Erfassen eines Fehlerzustands zu vergleichen, wobei die Steuerschaltung ferner zu Folgendem konfiguriert ist:
Überwachen des Widerstands des Heizelements während zumindest eines Heizvorgangs des Heizelements (48), um eine Vielzahl von überwachten Widerstandswerten über einen Zeitraum zu bestimmen;
Vergleichen von jedem aus der Vielzahl von überwachten Widerstandswerten mit dem vorbestimmten Schwellenwiderstandswert, und
Erfassen eines Fehlerzustands für das Heizelement basierend auf dem Vergleich der Vielzahl von überwachten Widerstandswerten mit dem vorbestimmten Schwellenwiderstandswert, wobei die Steuerschaltung konfiguriert ist, um den Fehlerzustand für das Heizelement in dem Fall zu erfassen, dass eine Vielzahl der überwachten Widerstandswerte den vorbestimmten Schwellenwiderstandswert während des Zeitraums überschreitet.

14. Verfahren zum Bedienen von Steuerschaltung (20) in einem Dampfbereitstellungssystem (1), wobei das Dampfbereitstellungssystem ein Heizelement (48) zum Erzeugen eines Dampfes aus einem Dampfvorläufermaterial umfasst, wobei die Steuerschaltung konfiguriert ist, um Leistung für das Heizelement bereitzustellen, um einen Heizvorgang auszuführen, um den Dampf zu erzeugen und um eine Messung eines Widerstandswertes für das Heizelement für einen Heizvorgang mit einem vorbestimmten Schwellenwiderstandswert für das Heizelement zur Verwendung beim Erfassen eines Fehlerzustands während des Heizvorgangs zu vergleichen; wobei das Verfahren umfasst, dass die Steuerschaltung:
den Widerstand des Heizelements während zumindest eines Heizvorgangs des Heizelements überwacht, um eine Vielzahl von überwachten Widerstandswerten über einen Zeitraum zu bestimmen;
jeden aus der Vielzahl von überwachten Widerstandswerten mit dem vorbestimmten Schwellenwiderstandswert vergleicht (304); und
einen Fehlerzustand (306) für das Heizelement basierend auf dem Vergleich der Vielzahl von überwachten Widerstandswerten mit dem vorbestimmten Schwellenwiderstandswert erfasst, wobei der Fehlerzustand für das Heizelement in dem Fall erfasst wird, dass eine Vielzahl der überwachten Widerstandswerte den vorbestimmten Schwellenwiderstandswert während des Zeitraums überschreitet.

## Revendications

1. Système de fourniture de vapeur (1) comprenant :
un élément chauffant (48) destiné à générer une vapeur à partir d'un matériau précurseur de vapeur ; et
des circuits de commande (20) configurés pour fournir de l'énergie afin de permettre à l'élément chauffant d'effectuer une opération de chauffe et de générer la vapeur et pour comparer une mesure d'une valeur de résistance pour l'élément chauffant pour l'opération de chauffe à une valeur de résistance seuil prédéterminée pour l'élément chauffant à utiliser dans la détection d'une condition de défaut, dans lequel les circuits de commande sont en outre configurés pour :
surveiller la résistance de l'élément chauffant pendant au moins une opération de chauffe de l'élément chauffant pour déterminer une pluralité de valeurs de résistance surveillées sur une période de temps ;
comparer chacune de la pluralité de valeurs de résistance surveillées à la valeur de résistance seuil prédéterminée ; et
détecter une condition de défaut pour l'élément chauffant sur la base de la comparaison de la pluralité de valeurs de résistance surveillées à la valeur de résistance seuil prédéterminée, dans lequel les circuits de commande sont configurés pour détecter ladite condition de défaut pour l'élément chauffant dans le cas où une pluralité des valeurs de résistance surveillées dépassent la valeur de résistance seuil prédéterminée pendant la période de temps.

2. Système de fourniture de vapeur selon la revendication 1, dans lequel la pluralité des valeurs de résistance surveillées qui dépassent la valeur de résistance seuil prédéterminée sont consécutives.

3. Système de fourniture de vapeur selon la revendication 1 ou 2, dans lequel la pluralité des valeurs de résistance surveillées qui dépassent la valeur de résistance seuil prédéterminée comprennent au moins deux valeurs de résistance surveillées qui dépassent la valeur de résistance seuil prédéterminée.

4. Système de fourniture de vapeur selon la revendication 3, dans lequel la pluralité des valeurs de résistance surveillées qui dépassent la valeur de résistance seuil prédéterminée comprennent au moins trois valeurs de résistance surveillées qui dépassent la valeur de résistance seuil prédéterminée.

5. Système de fourniture de vapeur selon l'une quelconque des revendications 1 à 4, dans lequel la période de temps est la durée d'une opération de chauffe de l'élément chauffant (48).

6. Système de fourniture de vapeur selon l'une quelconque des revendications 1 à 4, dans lequel la période de temps est la durée d'un nombre consécutif prédéterminé d'opérations de chauffe de l'élément chauffant (48).

7. Système de fourniture de vapeur selon la revendication 6, dans lequel le nombre consécutif prédéterminé d'opérations de chauffe de l'élément chauffant est de dix opérations de chauffe consécutives de l'élément chauffant (48).

8. Système de fourniture de vapeur selon l'une quelconque des revendications 1 à 4, dans lequel la période de temps comprend au moins 10 secondes, 30 secondes, 60 secondes ou 120 secondes.

9. Système de fourniture de vapeur selon l'une quelconque des revendications 1 à 8, dans lequel les circuits de commande (20) sont configurés, pour chaque valeur de résistance surveillée, pour détecter une condition de défaut si la valeur de résistance surveillée déterminée, et au moins une valeur de résistance surveillée déterminée précédente se produisant dans la période de temps avant que la valeur de résistance surveillée déterminée donnée ne soit déterminée, dépasse la valeur de résistance seuil prédéterminée.

10. Système de fourniture de vapeur selon l'une quelconque des revendications 1 à 9, dans lequel les circuits de commande (20) sont en outre configurés pour déterminer une valeur de résistance de base pour l'élément chauffant en effectuant une mesure d'une première valeur de résistance pour l'élément chauffant, dans lequel la valeur de résistance seuil est déterminée sur la base de la valeur de résistance de base.

11. Système de fourniture de vapeur selon la revendication 10, dans lequel la valeur de résistance seuil est un multiple prédéterminé de la valeur de résistance de base.

12. Système de fourniture de vapeur selon l'une quelconque des revendications 1 à 11, dans lequel le système comprend un capteur d'inhalation (16), et dans lequel les circuit de commande (20) sont configurés pour fournir de l'énergie à l'élément chauffant (48) pour permettre une opération de chauffe en réponse à un signal provenant du capteur d'inhalation qui indique qu'un utilisateur inhale sur le système de fourniture de vapeur.

13. Circuits de commande (20), destinés à être utilisés dans un système de fourniture de vapeur (1) pour générer une vapeur à partir d'un matériau précurseur de vapeur, dans lesquels les circuits de commande sont utilisables pour fournir de l'énergie à utiliser pour effectuer une opération de chauffe dans le système de fourniture de vapeur, et utilisables pour comparer une mesure d'une valeur de résistance pour l'opération de chauffe à une valeur de résistance seuil prédéterminée à utiliser pour détecter une condition de défaut, dans lesquels les circuits de commande sont en outre configurés pour :
surveiller la résistance de l'élément chauffant pendant au moins une opération de chauffe de l'élément chauffant (48) pour déterminer une pluralité de valeurs de résistance surveillées sur une période de temps ;
comparer chacune de la pluralité de valeurs de résistance surveillées à la valeur de résistance seuil prédéterminée ; et
détecter une condition de défaut pour l'élément chauffant sur la base de la comparaison de la pluralité de valeurs de résistance surveillées à la valeur de résistance seuil prédéterminée, dans lesquels les circuits de commande sont configurés pour détecter ladite condition de défaut pour l'élément chauffant dans le cas où une pluralité des valeurs de résistance surveillées dépassent la valeur de résistance seuil prédéterminée pendant la période de temps.

14. Procédé de fonctionnement de circuits de commande (20) dans un système de fourniture de vapeur (1), le système de fourniture de vapeur comprenant un élément chauffant (48) destiné à générer une vapeur à partir d'un matériau précurseur de vapeur, dans lequel les circuits de commande sont configurés pour fournir de l'énergie à l'élément chauffant pour lui permettre d'effectuer une opération de chauffe afin de générer la vapeur et pour comparer une mesure d'une valeur de résistance pour l'élément chauffant pour une opération de chauffe à une valeur de résistance seuil prédéterminée pour l'élément chauffant pour une utilisation dans la détection d'une condition de défaut pendant l'opération de chauffe ; dans lequel le procédé comprend, par les circuits de commande :
la surveillance de la résistance de l'élément chauffant pendant au moins une opération de chauffe de l'élément chauffant pour déterminer une pluralité de valeurs de résistance surveillées sur une période de temps ;
la comparaison (304) de chacune de la pluralité de valeurs de résistance surveillées à la valeur de résistance seuil prédéterminée ; et
la détection d'une condition de défaut (306) pour l'élément chauffant sur la base de la comparaison de la pluralité de valeurs de résistance surveillées à la valeur de résistance seuil prédéterminée, dans lequel la condition de défaut pour l'élément chauffant est détectée dans le cas où une pluralité des valeurs de résistance surveillées dépassent la valeur de résistance seuil prédéterminée pendant la période de temps.
